# EUROPÄISCHE PATENTSCHRIFT

(11) **EP 2 474 210 B1**
(45) Veröffentlichungstag und Bekanntmachung des Hinweises auf die Patenterteilung: **12.06.2013**
(21) Anmeldenummer: 10751888.8
(22) Anmeldetag: 24.08.2010
(51) Int. Cl.: H05K 3/10

(54) **VERFAHREN ZUR HERSTELLUNG VON ELEKTRISCH LEITFÄHIGEN OBERFLÄCHEN**
METHOD FOR PRODUCING ELECTRICALLY CONDUCTING SURFACES
PROCÉDÉ DE FABRICATION DE SURFACES ÉLECTRO-CONDUCTRICES

(30) Priorität: 04.09.2009 EP 09169550
(43) Veröffentlichungstag der Anmeldung: 11.07.2012
(73) Patentinhaber: BASF SE, 67056 Ludwigshafen (DE)
(72) Erfinder: KLEINE JÄGER, Frank, 67098 Bad Dürkheim (DE); KACZUN, Jürgen, 67157 Wachenheim (DE); LEHMANN, Udo, 55425 Waldalgesheim (DE)
(86) Internationale Anmeldenummer: PCT/EP2010/062311
(87) Internationale Veröffentlichungsnummer: WO 2011/026760

(56) Entgegenhaltungen:
- WO-A1-2008/055867
- US-A1- 2007 092 660

## Beschreibung

Die Erfindung betrifft ein Verfahren zur Herstellung von strukturierten oder vollflächigen, elektrisch leitfähigen Oberflächen auf einem Substrat, welches folgende Schritte umfasst:
(a) Übertragen von stromlos und/oder galvanisch beschichtbaren Partikeln oder einer stromlos und/oder galvanisch beschichtbare Partikel enthaltenden Dispersion von einem Transfermedium auf das Substrat,
(b) Fixieren der stromlos und/oder galvanisch beschichtbaren Partikel auf dem Substrat.

Strukturierte oder vollflächige, elektrisch leitfähige Oberflächen auf einem Substrat, die durch das erfindungsgemäße Verfahren hergestellt werden können, sind zum Beispiel Leiterbahnen auf Leiterplatten, RFID-Antennen, Transponderantennen oder andere Antennenstrukturen, Chipkartenmodule, Flachkabel, Sitzheizungen, Folienleiter, Leiterbahnen in LCD- oder Plasmabildschirmen oder galvanisch beschichtbare Produkte in beliebiger Form. Auch können die strukturierten oder vollflächigen Oberflächen als dekorative oder funktionale Oberflächen auf Produkten, die zur Abschirmung von elektromagnetischer Strahlung, zur Wärmeleitung oder als Verpackung verwendet werden, eingesetzt werden.

Im Allgemeinen wird zur Herstellung von strukturierten oder vollflächigen, elektrisch leitfähigen Oberflächen zunächst eine strukturierte oder vollflächige Haftschicht auf einen elektrisch nicht leitfähigen Träger aufgebracht. Auf dieser Haftschicht wird eine Metallfolie oder ein Metallpulver fixiert. Alternativ ist es auch bekannt, eine Metallfolie oder eine Metallschicht ganzflächig auf einen Trägerkörper aus einem Kunststoffmaterial aufzubringen und mithilfe eines strukturierten, erhitzten Stempels gegen den Trägerkörper zu pressen und durch anschließendes Aushärten zu fixieren. Die Strukturierung der Metallschicht erfolgt durch mechanisches Abtragen der nicht mit der Haftschicht oder mit dem Trägerkörper verbundenen Bereich der Metallfolie beziehungsweise des Metallpulvers. Ein derartiges Verfahren ist zum Beispiel in DE-A 101 45 749 beschrieben. Nachteil dieses Verfahrens ist es jedoch, dass nach dem Aufbringen der Basisschicht eine große Menge an Material wieder abgetragen werden muss, das zudem zum Teil nicht wiederverwertet werden kann. Im Falle der Metallfolie ist es nicht möglich, scharfe Kanten zu generieren, da die Folie nicht entsprechend übertragen werden kann. Diese scharfen Kanten werden jedoch zum Beispiel zur Herstellung von Leiterbahnen für zum Beispiel Leiterplatten oder RFID-Antennen gebraucht. Eine nicht sauber getrennte Folie würde zum Beispiel Kurzschlüsse verursachen. Im Falle des mechanischen Entfernens des überschüssigen Metallpulvers beziehungsweise der überschüssigen Folie können auch Leiterbahnstrukturen zum Teil entfernt werden, wodurch diese Leiterbahnen nicht mehr funktionsfähig sind.

Aus EP-A 0 130 462 ist es bekannt, eine Schicht aus einem wärmehärtenden Harz mit darin enthaltenen Metallpartikeln, wobei mindestens ein Teil der Partikel aus einem Edelmetall besteht, strukturiert auf eine Transferoberfläche aufzutragen. Anschließend wird das Transfermedium mit der Seite, auf der die das Harz und die Metallpartikel enthaltende Schicht aufgebracht ist, mit einem Trägerkörper in Kontakt gebracht. Dabei ist entweder auf die die Metallpartikel enthaltende Schicht oder auf den Trägerkörper eine Klebstoffschicht derart aufgetragen, dass die die Metallpartikel enthaltende Schicht in Form der herzustellenden strukturieren Oberfläche auf den Trägerkörper übertragen wird.

Nachteil dieses Verfahrens ist jedoch die Größe der verwendeten Metallpartikel im Bereich von 150 bis 420 µm, die es nicht ermöglichen, feinste Leiterbahnstrukturen, d.h. Leiterbahnstrukturen kleiner als 100 µm, zu erzeugen. Zudem benötigt das vorgeschlagene Verfahren einen signifikanten Anteil eines teuren Edelmetalls wie Silber. Ein weiterer Nachteil ist die Verwendung einer hochmetallgefüllten Druckfarbe, die sehr schwierig mit hoher Auflösung zu verdrucken ist. Außerdem wird dabei unnötig viel Metall übertragen, da die gesamte metallgefüllte Druckfarbenschicht vom Zwischenträger auf das Substrat übertragen wird, obwohl im weiteren Prozess nur eine dünne Metallschicht an der Oberfläche benötigt wird. Bei der Übertragung der strukturierten metallhaltigen Druckfarbe vom Zwischenträger auf das Substrat besteht die Gefahr, dass dünne Leiterbahnstrukturen nicht mit übertragen werden und es deshalb zu Fehlstellen in der Leiterbahn kommt. Ein weiterer Nachteil des Verfahrens ist, dass vor der Übertragung der strukturierten metallhaltigen Schicht ein zusätzlicher Kompaktierungsschritt vor der Übernahme der Metallschicht auf das Substrat benötigt wird, um eine ausreichende Leitfähigkeit für die anschließende Galvanisierung zu erzielen.

Ein weiteres Verfahren, bei dem stromlos und/oder galvanisch beschichtbare Partikel von einer stromlos und/oder galvanisch beschichtbare Partikel enthaltenden Dispersion von einem Transfermedium auf das Substrat übertragen werden und die Partikel auf dem Substrat fixiert werden, ist aus WO-A 2008/055867 bekannt. Nachteil ist jedoch auch hier, dass die aus dem Druckprozess resultierende Druckqualität in hohem Maße von der Homogenität der am Prozess beteiligten Parameter abhängig ist.

Aufgabe der vorliegenden Erfindung ist es, ein Verfahren zur Herstellung von strukturierten oder vollflächigen, elektrisch leitfähigen Oberflächen auf einem Substrat bereitzustellen, bei dem auch feine Strukturen mit sauberen Kanten gedruckt werden können.

Gelöst wird die Aufgabe durch ein Verfahren zur Herstellung von strukturierten oder vollflächigen, elektrisch leitfähigen Oberflächen auf einem Substrat, das gemäß Ansprunch 1 folgende Schritte umfasst:
(a) Übertragen von stromlos und/oder galvanisch beschichtbaren Partikeln oder einer stromlos und/oder galvanisch beschichtbare Partikel enthaltenden Dispersion von einem Transfermedium auf das Substrat,
(b) Fixieren der stromlos und/oder galvanisch beschichtbaren Partikel auf dem Substrat,
wobei die Partikel magnetisch oder magnetisierbar sind oder beim Übertragen einer Dispersion in der Dispersion magnetische oder magnetisierbare Partikel enthalten sind und zur Unterstützung des Übertragens in Schritt (a) ein Magnetfeld angelegt wird.

Durch das Anlegen des Magnetfeldes werden die stromlos und/oder galvanisch beschichtbaren Partikel beziehungsweise Tröpfchen der Dispersion, die die stromlos und/oder galvanisch beschichtbaren Partikel enthält, gezielter und direkter auf das Substrat übertragen. Hierdurch lässt sich eine verbesserte Druckqualität gegenüber den aus dem Stand der Technik bekannten Verfahren erzielen.

Das Übertragen der stromlos und/oder galvanisch beschichtbaren Partikel beziehungsweise der die stromlos und/oder galvanisch beschichtbare Partikel enthaltenden Dispersion erfolgt, indem Energie mit einem Laser von einer Vorrichtung zum Einbringen von Energie durch das Transfermedium in die Partikel beziehungsweise die Dispersion eingebracht wird. Hierbei berühren sich das Transfermedium und das zu bedruckende Substrat nicht. Durch das Anlegen des Magnetfeldes erfolgt trotz des Abstandes zwischen dem Transfermedium und dem zu bedruckenden Substrat eine Verbesserung des Druckbildes.

Der Abstand zwischen Transfermedium und zu bedruckendem Substrat wird im Allgemeinen als Druckspalt bezeichnet. Der Druckspalt weist vorzugsweise eine Spaltbreite von 0 bis 2 mm, weiter bevorzugt im Bereich von 0,01 bis 1 mm und insbesondere im Bereich von 0,05 bis 0,5 mm auf. Je kleiner der Druckspalt zwischen dem Transfermedium und dem Substrat ist, umso weniger weiten sich Tropfen beim Auftreffen auf das zu bedruckende Substrat auf und umso gleichmäßiger bleibt das Druckbild. Beim Einstellen des Druckspaltes ist jedoch darauf zu achten, dass das zu bedruckende Substrat, das mit den stromlos und/oder galvanisch beschichtbaren Partikeln beziehungsweise mit der die stromlos und/oder galvanisch beschichtbare Partikel enthaltenden Dispersion beschichtet wird, das Transfermedium nicht berührt, damit nicht an unerwünschten Stellen Partikel beziehungsweise die Partikel enthaltende Dispersion auf das zu bedruckende Substrat übertragen wird.

Als Transfermedium wird vorzugsweise ein flexibler Träger eingesetzt. Hierbei ist das Transfermedium vorzugsweise bandförmig ausgestaltet. Besonders bevorzugt ist das Transfermedium eine Folie. Die Dicke des Transfermediums liegt dabei vorzugsweise im Bereich von 1 bis ca. 500 µm, insbesondere im Bereich von 10 bis 200 µm. Es ist vorteilhaft, das Transfermedium in einer möglichst geringen Dicke auszuführen, damit die durch das Transfermedium eingebrachte Energie nicht im Transfermedium gestreut wird und so ein sauberes Druckbild erzeugt wird. Als Material für das Transfermedium eignen sich zum Beispiel für die eingesetzte Energie transparente Polymerfolien oder ein Glaszylinder.

In einer Ausführungsform einer für das erfindungsgemäße Verfahren geeigneten Druckmaschine ist das Transfermedium in einer geeigneten Vorrichtung bevorratet. Hierzu ist es zum Beispiel möglich, dass das Transfermedium, das mit den stromlos und/oder galvanisch beschichtbaren Partikeln beziehungsweise der die stromlos und/oder galvanisch beschichtbaren Partikel enthaltenden Dispersion beschichtet ist, zu einer Rolle aufgewickelt ist. Zum Bedrucken wird das beschichtete Transfermedium abgewickelt und über einen Druckbereich geführt, in dem mithilfe der Energie stromlos und/oder galvanisch beschichtbare Partikel beziehungsweise die Partikel enthaltende Dispersion auf das zu bedruckende Substrat übertragen wird. Anschließend wird das Transfermedium zum Beispiel wieder auf eine Rolle aufgewickelt, die dann zur Entsorgung gebracht werden kann. Bevorzugt ist es jedoch, dass das Transfermedium als umlaufendes Band ausgebildet ist. In diesem Fall werden die Partikel beziehungsweise die die Partikel enthaltende Dispersion mit einer geeigneten Auftragsvorrichtung auf das Transfermedium aufgebracht, bevor dieses die Druckposition, d.h. die Stelle, an der die Partikel beziehungsweise die die Partikel enthaltende Dispersion mithilfe des Energieeintrags vom Transfermedium auf das zu bedruckende Substrat übertragen werden, erreicht. Nach dem Druckvorgang ist ein Teil der Partikel beziehungsweise der die Partikel enthaltende Dispersion vom Träger auf das Substrat übertragen worden. Hierdurch befindet sich kein homogener Film mehr auf dem Träger. Für einen nächsten Druckvorgang ist es somit erforderlich, auf den Träger erneut Partikel beziehungsweise Partikel enthaltende Dispersion aufzubringen. Dies erfolgt zum Beispiel beim nächsten Durchlauf der entsprechenden Position an einer Farbauftragsvorrichtung. Um zu vermeiden, dass - insbesondere bei Verwendung einer Dispersion - die Dispersion am flexiblen Träger antrocknet und um jeweils eine gleichmäßige Schicht auf dem Transfermedium zu erzeugen, ist es vorteilhaft, vor einem nachfolgenden Auftrag von Partikeln beziehungsweise Partikel enthaltender Dispersion auf das Transfermedium zunächst die auf dem Transfermedium befindlichen Partikel beziehungsweise die Dispersion zu entfernen. Das Entfernen kann zum Beispiel mithilfe einer Rolle oder einem Rakel erfolgen. Wenn eine Rolle zum Abtragen der Partikel beziehungsweise der Dispersion eingesetzt wird, so ist es möglich, dass die gleiche Rolle verwendet wird, mit der auch die Partikel beziehungsweise die Dispersion auf den Träger aufgebracht wird. Hierzu ist es vorteilhaft, wenn die Drehbewegung der Rolle der Bewegung des Transfermediums entgegen gerichtet ist. Die vom Transfermedium entfernten Partikel beziehungsweise die entfernte Dispersion kann dann wieder einem Vorrat zugeführt werden. Wenn eine Rolle zum Abnehmen der Partikel beziehungsweise der Dispersion vorgesehen ist, ist es alternativ selbstverständlich auch möglich, dass eine Rolle zum Abnehmen der Partikel beziehungsweise der Dispersion vorgesehen ist und eine Rolle zum Auftragen der Partikel beziehungsweise der Dispersion.

Wenn die Partikel beziehungsweise die die Partikel enthaltene Dispersion mit einem Rakel vom Transfermedium entfernt werden soll, kann jeder beliebige, dem Fachmann bekannte Rakel eingesetzt werden.

Um zu vermeiden, dass das Transfermedium beim Auftragen der Partikel beziehungsweise der die Partikel enthaltende Dispersion oder beim Abnehmen der Partikel beziehungsweise der die Partikel enthaltenden Dispersion beschädigt wird, ist es bevorzugt, wenn das Transfermedium mithilfe einer Gegenwalze gegen die Auftragswalze, mit der die Partikel beziehungsweise die Partikel enthaltende Dispersion auf das Transfermedium aufgebracht wird oder die Rolle, mit der die Partikel beziehungsweise die Partikel enthaltende Dispersion vom Transfermedium entfernt wird, oder dem Rakel, mit dem die Partikel beziehungsweise die Partikel enthaltende Dispersion vom Transfermedium entfernt wird, gedrückt wird. Der Gegendruck wird dabei so eingestellt, dass die Partikel beziehungsweise die die Partikel enthaltende Dispersion im Wesentlichen vollständig entfernt wird, es jedoch nicht zu einer Schädigung des Transfermediums kommt.

Die Energie wird vorzugsweise fokussiert durch das Transfermedium in die Partikel beziehungsweise die Partikel enthaltende Dispersion eingebracht. Hierdurch lässt sich eine Verbesserung des Druckbildes erzielen. Die Größe des Punktes, auf den die einzubringende Energie fokussiert wird, entspricht dabei der Größe des zu übertragenden Punktes in Abhängigkeit vom Substrat. Im Allgemeinen weisen zu übertragende Punkte einen Durchmesser von ca. 20 µm bis ca. 200 µm auf. Die Größe des zu übertragenden Punktes kann jedoch in Abhängigkeit vom zu bedruckenden Substrat und dem damit herzustellenden Druckerzeugnis abweichen. So ist es zum Beispiel möglich, insbesondere bei der Herstellung von bedruckten Leiterplatten, einen größeren Fokus zu wählen. Dagegen werden bei Druckerzeugnissen, bei denen eine Schrift dargestellt wird, im Allgemeinen kleinere Druckpunkte zum Erzeugen eines klaren Schriftbildes bevorzugt. Auch beim Drucken von Bildern und Grafiken ist es vorteilhaft, möglichst kleine Punkte zu drucken, um ein klares Bild zu erzeugen.

Die Energie, die eingesetzt wird, um die Partikel beziehungsweise die Partikel enthaltende Dispersion auf das zu bedruckende Substrat zu übertragen, ist ein Laser. Vorteil eines Lasers ist, dass der eingesetzte Laserstrahl auf einen sehr kleinen Querschnitt gebündelt werden kann. Ein zielgerichteter Energieeintrag ist somit möglich. Das Übertragen der Partikel beziehungsweise der die Partikel enthaltenden Dispersion erfolgt durch zumindest teilweise Verdampfung, wodurch sich die Partikel beziehungsweise die Partikel enthaltende Dispersion vom Transfermedium löst und auf das Substrat übertragen wird. Hierzu ist es notwendig, das Licht des Lasers in Wärme umzuwandeln. Dies kann einerseits dadurch erfolgen, dass die Partikel beziehungsweise die die Partikel enthaltende Dispersion einen geeigneten Absorber enthält, der das Laserlicht absorbiert und in Wärme umwandelt. Alternativ ist es auch möglich, dass das Transfermedium mit einem entsprechenden Absorber beschichtet ist oder aus einem solchen Absorber gefertigt ist, beziehungsweise einen solchen Absorber enthält, der das Laserlicht absorbiert und in Wärme umwandelt. Bevorzugt ist es jedoch, dass das Transfermedium aus einem für die Laserstrahlung transparenten Material gefertigt ist und der Absorber, der das Laserlicht in Wärme umwandelt, in den Partikeln beziehungsweise in der die Partikel enthaltenden Dispersion enthalten ist.

Als Absorber eignen sich zum Beispiel Kohlenstoffpartikel in Form von Ruß, Graphit, Kohlenstoffnanoröhrchen oder Graphenen, nanopartikuläre Metalle, beispielsweise Silber-Nanopartikel, Metallnitride, Metalloxide oder feinteiliges Lanthanhexaborid mit Teilchengrößen im Bereich von 0,01 bis 1 µm, bevorzugt im Bereich von 0,02 bis 0,5 µm und insbesondere im Bereich von 0,03 bis 0,2 µm.

Als Laser zum Einbringen der Energie kann jeder beliebige, dem Fachmann bekannte Laser eingesetzt werden. Bevorzugt wird ein Festkörperlaser, ein Faserlaser, ein Diodenlaser, ein Gas-Laser oder ein Excimer-Laser verwendet. Der eingesetzte Laser erzeugt vorzugsweise einen Laserstrahl mit einer Wellenlänge im Bereich von 150 bis 10600 nm, insbesondere in einem Bereich von 600 bis 1200 nm.

Wenn zur Beschichtung eine Dispersion eingesetzt wird, können die auf das Substrat zu übertragenden stromlos und/oder galvanisch beschichtbaren Partikel Partikel mit beliebiger Geometrie aus jedem beliebigen stromlos und/oder galvanisch beschichtbaren Material, aus Mischungen verschiedener stromlos und/oder galvanisch beschichtbaren Materialien oder auch aus Mischungen von stromlos und/oder galvanisch beschichtbaren und nicht stromlos und/oder galvanisch beschichtbaren Materialien sein. Geeignete stromlos und/oder galvanisch beschichtbare Materialien sind zum Beispiel Kohlenstoff, beispielsweise als Ruß, Graphit, Kohlenstoffnanoröhrchen oder Graphenen, elektrisch leitfähige Metallkomplexe, leitfähige organische Verbindungen oder leitfähige Polymere oder Metalle, vorzugsweise Zink, Nickel, Kupfer, Zinn, Kobalt, Mangan, Eisen, Magnesium, Blei, Chrom, Wismut, Silber, Gold, Aluminium, Titan, Palladium, Platin, Tantal sowie Legierungen hiervon oder Metallgemische, die mindestens eines dieser Metalle enthalten. Geeignete Legierungen sind beispielsweise CuZn, CuSn, CuNi, SnPb, SnBi, SnCo, NiPb, ZnFe, ZnNi, ZnCo und ZnMn. Insbesondere bevorzugt als Material für die stromlos und/oder galvanisch beschichtbaren Partikel sind Aluminium, Eisen, Kupfer, Nickel, Zink, Kohlenstoff sowie deren Mischungen.

Besonders bevorzugt ist es, wenn die stromlos und/oder galvanisch beschichtbaren Partikel ein magnetisierbares Material enthalten oder magnetisch sind. Geeignete Materialien sind zum Beispiel Metalle wie Eisen, Nickel, Cobalt oder Legierungen wie NiFe, NiCuCo, NiCoFe, AlNi, AlNiCo, FeCoV, FeCo, FeSi, MnAICu₂, SmCo und Nd₂Fe₁₄B.

Die stromlos und/oder galvanisch beschichtbaren Partikel besitzen vorzugsweise einen mittleren Teilchendurchmesser von 0, 001 bis 100 µm, bevorzugt von 0, 005 bis 50 µm und insbesondere bevorzugt von 0, 01 bis 10 µm. Der mittlere Teilchendurchmesser kann mittels Laserbeugungsmessung beispielsweise an einem Gerät Microtrac X100 ermittelt werden. Die Verteilung der Teilchendurchmesser hängt von deren Herstellverfahren ab. Typischerweise weist die Durchmesserverteilung nur ein Maximum auf, mehrere Maxima sind jedoch auch möglich.

Die Oberfläche der stromlos und/oder galvanisch beschichtbaren Partikel kann zumindest teilweise mit einer Beschichtung ("Coating") versehen sein. Geeignete Coatings können anorganischer (zum Beispiel SiO₂, Phosphate) oder organischer Natur sein. Selbstverständlich können die stromlos und/oder galvanisch beschichtbaren Partikel auch mit einem Metall oder Metalloxid beschichtet sein. Ebenfalls kann das Metall in teilweise oxidierter Form vorliegen.

Sollen zwei oder mehr unterschiedliche Sorten stromlos und/oder galvanisch beschichtbarer Partikel eingesetzt werden, so kann dies durch eine Mischung dieser Sorten erfolgen. Insbesondere bevorzugt ist es, wenn die Sorten ausgewählt sind aus der Gruppe bestehend aus Eisen, Nickel, Cobalt, FeNi und FeNiCo.

Die stromlos und/oder galvanisch beschichtbaren Partikel können jedoch auch ein erstes Metall und ein zweites Metall enthalten, bei dem das zweite Metall in Form einer Legierung (mit dem ersten Metall oder einem oder mehreren anderen Metallen) vorliegt, oder die stromlos und/oder galvanisch beschichtbaren Partikel enthalten zwei unterschiedliche Legierungen.

Wenn die in der Dispersion eingesetzten stromlos und/oder galvanisch beschichtbaren Partikel nicht magnetisch oder magnetisierbar sind, sind in der Dispersion zusätzlich Partikel enthalten, die ein magnetisches oder magnetisierbares Material enthalten. Bevorzugt ist es jedoch, wenn die verwendeten stromlos und/oder galvanisch beschichtbaren Partikel ein magnetisches oder magnetisierbares Material enthalten.

Wenn keine Dispersion sondern nur Partikel übertragen werden, enthalten die Partikel erfindungsgemäß ein magnetisches oder magnetisierbares Material.

Wenn eine Dispersion eingesetzt wird, die die stromlos und/oder galvanisch beschichtbaren Partikel enthält, so enthält diese weiterhin mindestens ein Lösungsmittel und ein Bindemittel als Matrixmaterial. Zusätzlich kann die Dispersion weitere Additive, beispielsweise geeignete Absorber, Dispergierhilfsmittel und Verlaufshilfsmittel, Korrosionsinhibitoren usw. enthalten.

Geeignete Lösungsmittel sind zum Beispiel aliphatische und aromatische Kohlenwasserstoffe (zum Beispiel n-Octan, Cyclohexan, Toluol, Xylol), Alkohole (zum Beispiel Methanol, Ethanol, 1-Propanol, 2-Propanol, 1-Butanol, 2-Butanol, Amylalkohol), mehrwertige Alkohole wie Glycerin, Ethylenglykol, Propylenglykol, Neopentylglykol, Alkylester (zum Beispiel Methylacetat, Ethylacetat, Propylacetat, Butylacetat, Isobutylacetat, Isopropylacetat, 3-Methylbutanol), Alkoxyalkohole (zum Beispiel Methoxypropanol, Methoxybutanol, Ethoxypropanol), Alkylbenzole (zum Beispiel Ethylbenzol, Isopropylbenzol), Butylglykol, Butyldiglykol, Alkylglykolacetate (zum Beispiel Butylglykolacetat, Butyldiglykolacetat), Diacetonalkohol, Diglykoldialkylether, Diglykolmonoalkylether, Dipropylenglykoldialkylether, Dipropylenglykolmonoalkylether, Diglykolalkyletheracetate, Dipropylenglykolalkyletheracetate, Dioxan, Dipropylenglykol und -ether, Diethylenglykol und -ether, DBE (dibasic Ester), Ether (zum Beispiel Diethylether, Tetrahydrofuran), Ethylenchlorid, Ethylenglykol, Ethylenglykolacetat, Ethylenglykoldimethylester, Kresol, Lactone (zum Beispiel Butyrolacton), Ketone (zum Beispiel Aceton, 2-Butanon, Cyclohexanon, Methylethylketon (MEK), Methylisobutylketon (MIBK)), Methyldiglykol, Methylenchlorid, Methylenglykol, Methylglykolacetat, Methylphenol (ortho-, meta-, para-Kresol), Pyrrolidone (zum Beispiel N-Methyl-2-pyrrolidon), Propylenglykol, Propylencarbonat, Tetrachlorkohlenstoff, Toluol, Trimethylolpropan (TMP), aromatische Kohlenwasserstoffe und Gemische, aliphatische Kohlenwasserstoffe und Gemische, alkoholische Monoterpene (wie zum Beispiel Terpineol), Wasser sowie Mischungen aus zwei oder mehreren dieser Lösemittel.

Bevorzugte Lösemittel sind Alkohole (zum Beispiel Ethanol, 1-Propanol, 2-Propanol, Butanol), Alkoxyalhohole (zum Beispiel Methoxypropanol, Ethoxypropanol, Butylglykol, Butyldiglykol), Butyrolacton, Diglykoldialkylether, Diglykolmonoalkylether, Dipropylenglykoldialkylether, Dipropylenglykolmonoalkylether, Ester (zum Beispiel Ethylacetat, Butylacetat, Butylglykolacetat, Butyldiglykolacetat, Diglykolalkyletheracetate, Dipropylenglykolalkyletheracetate, DBE), Ether (zum Beispiel Tetrahydrofuran), mehrwertige Alkohole wie Glycerin, Ethylenglykol, Propylenglykol, Neopentylglykol, Ketone (zum Beispiel Aceton, Methylethylketon, Methylisobutylketon, Cyclohexanon), Kohlenwasserstoffe (zum Beispiel Cyclohexan, Ethylbenzol, Toluol, Xylol), N-Methyl-2-pyrrolidon, Wasser sowie Mischungen davon.

Auch Mischungen von Wasser und organischen Lösungsmitteln sind möglich.

Vorzugsweise handelt es sich bei dem Matrixmaterial um ein Polymer oder Polymergemisch.

Bevorzugte Polymere als Matrixmaterial sind ABS (Acrylnitril-Butadien-Styrol); ASA (Acrylnitril-Styrol-Acrylat); acrylierte Acrylate; Alkydharze; Alkylvinylacetate; Alkylenvinylacetat-Copolymere, insbesondere Methylenvinylacetat, Ethylenvinylacetat, Butylenvinylacetat; Alkylenvinylchlorid-Copolymere; Aminoharze; Aldehyd- und Ketonharze; Cellulose und Cellulosederivate, insbesondere Hydroxyalkylcellulose, Celluloseester, wie -Acetate, -Propionate, -Butyrate, Carboxyalkylcellulosen, Cellulosenitrat; Epoxyacrylate; Epoxidharze; modifizierte Epoxidharze, zum Beispiel bifunktionelle oder polyfunktionelle Bisphenol A- oder Bisphenol F-Harze, Epoxy-Novolak-Harze, bromierte Epoxidharze, cycloaliphatische Epoxidharze; aliphatische Epoxidharze, Glycidether, Vinylether, Ethylenacrylsäurecopolymere; Kohlenwasserstoffharze; MABS (transparentes ABS mit Acrylat-Einheiten enthaltend); Melaminharze, Maleinsäureanhydridcopolymerisate; Methacrylate; Naturkautschuk; synthetischer Kautschuk; Chlorkautschuk; Naturharze; Kollophoniumharze; Schellack; Phenolharze; Polyester; Polyesterharze, wie Phenylesterharze; Polysulfone; Polyethersulfone; Polyamide; Polyimide; Polyaniline; Polypyrrole; Polybutylenterephthalat (PBT); Polycarbonat (zum Beispiel Makrolon® der Bayer AG); Polyesteracrylate; Polyetheracrylate; Polyethylen; Polyethylenthiophene; Polyethylennaphthalate; Polyethylenterephthalat (PET); Polyethylenterephthalat-Glykol (PETG); Polypropylen; Polymethylmethacrylat (PMMA); Polyphenylenoxid (PPO); Polystyrole (PS), Polytetrafluorethylen (PTFE); Polytetrahydrofuran; Polyether (zum Beispiel Polyethylenglykol, Polypropylenglykol), Polyvinylverbindungen, insbesondere Polyvinylchlorid (PVC), PVC-Copolymere, PVdC, Polyvinylacetat sowie deren Copolymere, gegebenenfalls teilhydrolysierter Polyvinylalkohol, Polyvinylacetale, Polyvinylacetate, Polyvinylpyrrolidon, Polyvinylether, Polyvinylacrylate und -methacrylate in Lösung und als Dispersion sowie deren Copolymere, Polyacrylsäureester und Polystyrolcopolymere; Polystyrol (schlagfest oder nicht schlagfest modifiziert); Polyurethane, unvernetzte beziehungsweise mit Isocyanaten vernetzt; Polyurethanacrylate; Styrol-Acryl-Copolymere; Styrol-Butadien-Blockcopolymere (zum Beispiel Styroflex^{®} oder Styrolux^{®} der BASF AG, K-Resin™ der CPC); Proteine, wie zum Beispiel Casein; SIS; Triazin-Harz, Bismaleimid-Triazin-Harz (BT), Cyanatester-Harz (CE), Allylierter Polyphenylen-ether (APPE). Weiterhin können Mischungen zweier oder mehrerer Polymere das Matrixmaterial bilden.

Besonders bevorzugte Polymere als Matrixmaterial sind Acrylate, Acrylatharze, Cellulosederivate, Methacrylate, Methacrylatharze, Melamin und Aminoharze, Polyalkylene, Polyimide, Epoxidharze, modifizierte Epoxidharze, zum Beispiel bifunktionelle oder polyfunktionelle Bisphenol A- oder Bisphenol F-Harze, Epoxy-Novolak-Harze, bromierte Epoxidharze, cycloaliphatische Epoxidharze; aliphatische Epoxidharze, Glycidether, Vinylether, und Phenolharze, Polyurethane, Polyester, Polyvinylacetale, Polyvinylacetate, Polystyrole, Polystyrol-Copolymere, Polystyrolacrylate, Styrol-Butadien-Blockcopolymere, Alkylenvinylacetate und Vinylchlorid-Copolymere, Polyamide sowie deren Copolymere.

Bei der Herstellung von Leiterplatten werden als Matrixmaterial für die Dispersion bevorzugt thermisch oder strahlungshärtende Harze, zum Beispiel modifizierte Epoxidharze, wie bifunktionelle oder polyfunktionelle Bisphenol A- oder Bisphenol F-Harze, Epoxy-Novolak-Harze, bromierte Epoxidharze, cycloaliphatische Epoxidharze; aliphatische Epoxidharze, Glycidether, Cyanatester, Vinylether, Phenolharze, Polyimide, Melaminharze und Aminoharze, Polyurethane, Polyester sowie Cellulosederivate eingesetzt.

Weiterhin ist es bevorzugt, wenn die Dispersion ein Absorptionsmittel, beispielsweise Ruß, nanopartikuläre Metalle wie Silber-Nanopartikel, Metallnitride, Metalloxide oder feinteiliges Lanthanhexaborid mit Teilchengrößen von 0,01 bis 1 µm, bevorzugt 0,02 bis 0,5 µm und insbesondere 0,03 bis 0,2 µm enthält.

Wenn eine Dispersion auf das Substrat gedruckt werden soll, so ist es vorteilhaft, wenn die Dispersion magnetische oder magnetisierbare Partikel enthält. Hierbei ist es einerseits möglich, dass die stromlos und/oder galvanisch beschichtbaren Partikel auch magnetisch oder magnetisierbar sind. Alternativ ist es möglich, zum Beispiel Funktionspigmente einzusetzen, die magnetisch oder magnetisierbar sind. Auch können magnetische oder magnetisierbare stromlos und/oder galvanisch beschichtbare Partikel und magnetische oder magnetisierbare Funktionspartikel eingesetzt werden. Die magnetischen beziehungsweise magnetisierbaren Partikel können ferromagnetisch sein, hierzu ist es zum Beispiel möglich ein Eisenoxid (Fe₃O₄) oder ein Eisenpulver zu verwenden mit einer Partikelgröße von mehr als 1 µm. Auch können paramagnetische Partikel verwendet werden. Hierzu ist es zum Beispiel möglich, Eisenoxid (Fe₃O₄) oder Eisenpulver mit einer Partikelgröße von weniger als 1 µm einzusetzen.

Erfindungsgemäß wird zur Unterstützung des Übertragens der stromlos und/oder galvanisch beschichtbaren Partikel beziehungsweise der die stromlos und/oder galvanisch beschichtbaren Partikel enthaltenden Dispersion ein Magnetfeld angelegt. Hierzu ist es bevorzugt, das Magnetfeld mit einem Magneten zu erzeugen, der unterhalb des zu beschichtenden Substrats angeordnet ist. Alternativ ist es selbstverständlich auch möglich, den Magneten oberhalb des zu beschichtenden Substrats anzuordnen. Bevorzugt ist jedoch die Anordnung unterhalb des zu beschichtenden Substrats. Bei Einsatz von magnetischen oder magnetisierbaren Partikeln beziehungsweise Zugabe von magnetischen oder magnetisierbaren Partikeln in die Dispersion erfolgt die Übertragung der Partikel beziehungsweise der Dispersion entlang der Feldlinien des Magnetfeldes. Hierdurch ist eine gezielte Übertragung möglich und das Druckbild wird verbessert. Durch die Anordnung des Magneten unterhalb des zu bedruckenden Substrates verlaufen die Feldlinien des Magnetfeldes im Druckbereich im Wesentlichen parallel zur Druckrichtung. Hierdurch ist ein gezieltes Bedrucken des Substrates möglich.

Als Magnete, mit denen das Magnetfeld erzeugt wird, kann jeder beliebige, dem Fachmann bekannte Magnet eingesetzt werden. So ist es einerseits möglich, Permanentmagnete zu verwenden, andererseits können auch Elektromagnete eingesetzt werden. Bevorzugt ist die Verwendung von Elektromagneten, da diese schaltbar sind. Ein weiterer Vorteil von Elektromagneten ist, dass wechselnde Magnetfelder erzeugt werden können. Hierdurch ist es zum Beispiel möglich, wechselnde Magnetfelder anzulegen und gemäß dem zu verdruckenden Motiv in der Intensität anzupassen oder zu verändern.

Im Unterschied zu einer elektrostatischen Druckunterstützung ist ein weiterer Vorteil der Druckunterstützung durch Anlegen eines Magnetfeldes, dass das zu bedruckende Substrat selbst kein Träger einer Ladung sein muss, im Gegensatz zu einem elektrostatisch aufgeladenen Substrat bei elektrostatischer Druckunterstützung. Die magnetischen Feldlinien können über eine relativ große Distanz durch das Substrat hindurch wirken, ohne dabei Einfluss auf das Substrat zu nehmen. Auch ist es möglich, Substrate zu bedrucken, die aus einem Metall oder Halbleiter bestehen beziehungsweise ein Metall oder einen Halbleiter enthalten.

Durch die Unterstützung des Übertragens durch Anlegen eines Magnetfelds kann zudem die für die Übertragung notwendige Laserenergie gegenüber Verfahren ohne Unterstützung durch Anlegen eines Magnetfeldes möglicherweise reduziert werden.

In einer Ausführung der Erfindung wird zum Erzeugen des Magnetfelds ein Array mit adressierbaren Magnetbereichen eingesetzt. Hierdurch ist es möglich, wechselnde Magnetfelder oder Magnetfelder in unterschiedlicher Intensität einzusetzen. Wenn zum Erzeugen des Magnetfelds ein Array mit adressierbaren Magnetbereichen eingesetzt wird, so wird vorzugsweise eine magnetische Zeile direkt unterhalb des Druckspaltes installiert. Diese Zeile ist in Teile segmentiert, die bis zu einer Feinheit in Druckauflösung in ihrer magnetischen Intensität gesteuert oder umgepolt werden können. Die Steuerung des Magnetfelds erfolgt dabei vorzugsweise digital. Durch Verwendung eines Arrays mit adressierbaren Magnetbereichen ist es möglich, das Magnetfeld an das zu erzeugende Druckbild anzupassen.

Nach dem Aufbringen der stromlos und/oder galvanisch beschichtbaren Partikel auf das Substrat ist es möglich, die so erzeugte Oberfläche nach dem Trocknen und/oder Aushärten stromlos und/oder galvanisch zu beschichten. Durch die Beschichtung wird eine durchgehende Schicht erzielt, die beispielsweise als Leiterbahn verwendet werden kann.

Das erfindungsgemäße Verfahren eignet sich zum Beispiel zur Herstellung von Leiterplatten, RFID-Antennen, Transponderantennen, Flachkabeln, Chipkartenmodulen, Sitzheizungen, Folienleitern oder Leiterbahnen in LCD- oder Plasmabildschirmen.

Ausführungsbeispiele der Erfindung sind in den Figuren dargestellt und werden in der nachfolgenden Beschreibung näher erläutert.

Es zeigen:
- Figur 1: eine schematische Darstellung des erfindungsgemäßen Verfahrens mit einem Magneten,
- Figur 2: eine schematische Darstellung eines einzelnen Magneten,
- Figur 3: eine schematische Darstellung eines Arrays mit adressierbaren Magnetbereichen.

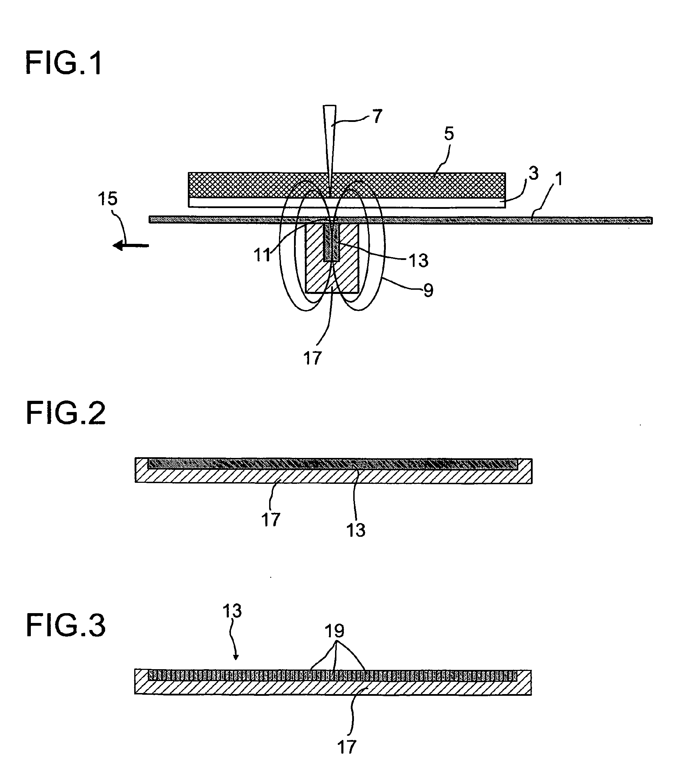

In Figur 1 ist das erfindungsgemäße Verfahren schematisch dargestellt.

Zum Bedrucken eines Substrates 1 werden stromlos und/oder galvanisch beschichtbare Partikel beziehungsweise eine stromlos und/oder galvanisch beschichtbare Dispersion 3 von einem Transfermedium 5 auf das Substrat 1 übertragen. Um die stromlos und/oder galvanisch beschichtbaren Partikel beziehungsweise die stromlos und/oder galvanisch beschichtbare Partikel enthaltende Dispersion 3 vom Transfermedium 5 auf das Substrat 1 zu übertragen, wird Energie in die stromlos und/oder galvanisch beschichtbaren Partikel beziehungsweise die die stromlos und/oder galvanisch beschichtbare Partikel enthaltende Dispersion 3 eingebracht. Das Einbringen der Energie erfolgt zum Beispiel durch einen Laser 7.

Durch die mit dem Laser 7 eingebrachte Energie werden die stromlos und/oder galvanisch beschichtbaren Partikel beziehungsweise die die stromlos und/oder galvanisch beschichtbare Partikel enthaltende Dispersion zumindest teilweise verdampft. Hierdurch lösen sich die stromlos und/oder galvanisch beschichtbaren Partikel beziehungsweise die die stromlos und/oder galvanisch beschichtbaren Partikel enthaltende Dispersion 3 vom Transfermedium 5 und wird auf das Substrat 1 übertragen.

Damit das Licht des Lasers 7 in Wärme umgewandelt wird, mit der die stromlos und/oder galvanisch beschichtbaren Partikel beziehungsweise die die stromlos und/oder galvanisch beschichtbare Partikel enthaltende Dispersion 3 zumindest teilweise verdampft wird, enthalten entweder die Partikel oder die Partikel enthaltende Dispersion 3 einen geeigneten Absorber für das Laserlicht. Als Absorber eignen sich zum Beispiel Ruß, nanopartikuläre Metalle wie Silber-Nanopartikel, Metallnitride, Metalloxide oder feinteiliges Lanthanhexaborid mit Teilchengrößen im Bereich von 0,01 bis 1 µm, bevorzugt im Bereich von 0,02 bis 0,5 µm und insbesondere im Bereich von 0,03 bis 0,2 µm.

Erfindungsgemäß wird das Übertragen der stromlos und/oder galvanisch beschichtbaren Partikel beziehungsweise der die stromlos und/oder galvanisch beschichtbare Partikel enthaltenden Dispersion 3 durch Anlegen eines Magnetfeldes 9 unterstützt. Zum Anlegen des Magnetfeldes 9 ist am Druckbereich 11, d.h. dem Bereich, in dem die stromlos und/oder galvanisch beschichtbaren Partikel beziehungsweise die die stromlos und/oder galvanisch beschichtbare Partikel enthaltende Dispersion 3 vom Transfermedium 5 auf das Substrat 1 übertragen wird, ein Magnet 13 positioniert. Wenn das Substrat 1 zeilenweise bedruckt wird, so wird das Substrat 1 wie in Figur 1 mit einem Pfeil 15 dargestellt quer zur Zeilendruckrichtung bewegt. Die Zeile wird jeweils durch Verfahren des Lasers 7 gedruckt. Um über die gesamte Zeilenbreite eine Magnetunterstützung zu erhalten, erstreckt sich der Magnet 13 vorzugsweise über die gesamte zu druckende Zeilenbreite.

Um den Magneten 9 zu positionieren ist dieser in einer geeigneten Halterung 17 aufgenommen.

Als Magnet eignen sich sowohl Permanentmagnete als auch Elektromagnete. Bevorzugt sind jedoch Elektromagnete, da diese schaltbar sind und somit die Stärke des Magnetfeldes 9 eingestellt werden kann. Auch ist es möglich, hierdurch Einfluss auf das Druckbild zu nehmen. So lässt sich zum Beispiel durch Einstellung des Magnetes die zu druckende Schichtdicke und damit die Intensität anpassen.

In Figur 2 ist ein Magnet in einer Halterung in einer ersten Ausführungsform dargestellt. In der in Figur 2 dargestellten Ausführungsform wird ein einzelner Magnet 13 eingesetzt. Das bedeutet, dass über die gesamte zu bedruckende Zeilenbreite ein homogenes Magnetfeld erzeugt wird.

Eine weitere Ausführungsform ist in Figur 3 dargestellt. Bei der in Figur 3 dargestellten Ausführungsform ist der Magnet 13 ein Array mit adressierbaren Magnetbereichen 19. Die Magnetbereiche 19 sind jeweils einzeln ansteuerbar, wodurch das Magnetfeld digital und punktuell verändert werden kann. Bevorzugt entsprechen die einzelnen Magnetbereiche 19 der mit dem Laser 7 erzielbaren Druckauflösung. Hierdurch lässt sich gezielt die Intensität jedes einzelnen zu druckenden Punktes einstellen. Die Ansteuerung der einzelnen Magnetbereiche 19 erfolgt dabei vorzugsweise über ein geeignetes Steuergerät.

### Bezugszeichenliste

| | |
|---|---|
| 1 | Substrat |
| 3 | Dispersion |
| 5 | Transfermedium |
| 7 | Laser |
| 9 | Magnetfeld |
| 11 | Druckbereich |
| 13 | Magnet |
| 15 | Bewegung des Substrats 1 |
| 17 | Halterung |
| 19 | Magnetbereich |

## Patentansprüche

1. Verfahren zur Herstellung von strukturierten oder vollflächigen, elektrisch leitfähigen Oberflächen auf einem Substrat (1), folgende Schritte umfassend:
a. Übertragen von stromlos und/oder galvanisch beschichtbaren Partikeln oder einer stromlos und/oder galvanisch beschichtbare Partikel enthaltenden Dispersion (3) von einem Transfermedium (5) auf das Substrat (1), wobei zum Übertragen der stromlos und/oder galvanisch beschichtbaren Partikel Energie mit einem Laser (7) in die stromlos und/oder galvanisch beschichtbaren Partikel oder die die stromlos und/oder galvanisch beschichtbaren Partikel enthaltenden Dispersion (3) eingebracht wird,
b. Fixieren der stromlos und/oder galvanisch beschichtbaren Partikel auf dem Substrat (1),
**dadurch gekennzeichnet, dass** zur Unterstützung des Übertragens in Schritt (a) die Partikel magnetisch oder magnetisierbar sind oder beim Übertragen einer Dispersion in der Dispersion magnetische oder magnetisierbare Partikel enthalten sind und ein Magnetfeld (9) angelegt wird.

2. Verfahren gemäß Anspruch 1, **dadurch gekennzeichnet, dass** das Magnetfeld (9) mit einem Magneten (13) erzeugt wird, der unterhalb des zu beschichtenden Substrats (1) angeordnet ist.

3. Verfahren gemäß Anspruch 1 oder 2, **dadurch gekennzeichnet, dass** zum Erzeugen des Magnetfelds ein Array mit adressierbaren Magnetbereichen (19) eingesetzt wird.

4. Verfahren gemäß einem der Ansprüche 1 bis 3, **dadurch gekennzeichnet, dass** der Laser (7) ein Festkörperlaser, ein Faserlaser, ein Diodenlaser, ein Gas-Laser oder ein Excimer-Laser ist.

5. Verfahren gemäß einem der Ansprüche 1 bis 4 oder 5, **dadurch gekennzeichnet, dass** der Laser (7) einen Laserstrahl mit einer Wellenlange im Bereich von 150 bis 10600 nm erzeugt.

6. Verfahren gemäß einem der Ansprüche 1 bis 5, **dadurch gekennzeichnet, dass** die stromlos und/oder galvanisch beschichtbaren Partikel ein magnetisierbares Material enthalten.

7. Verfahren gemäß Anspruch 6, **dadurch gekennzeichnet, dass** das magnetisierbare Material Eisen, Nickel, Cobalt, NiFe, NiCuCo, NiCoFe, AlNi, AlNiCo, FeCoV, FeCo, FeSi, MnACu₂, SmCo oder Nd₂Fe₁₄B ist.

8. Verfahren gemäß einem der Ansprüche 1 bis 7, **dadurch gekennzeichnet, dass** die Dispersion (3) ein Absorptionsmittel enthält.

9. Verfahren gemäß einem der Ansprüche 1 bis 8, **dadurch gekennzeichnet, dass** die elektrisch leitfähige Oberfläche nach dem Trocknen und/oder Aushärten stromlos und/oder galvanisch beschichtet wird.

10. Verfahren gemäß einem der Ansprüche 1 bis 9, **dadurch gekennzeichnet, dass** das Transfermedium (5) ein für die verwendete Laserstrahlung durchlässiger starrer oder flexibler Kunststoff oder Glas ist.

11. Verfahren gemäß einem der Ansprüche 1 bis 10 zur Herstellung von Leiterplatten, RFID-Antennen, Transponderantennen, Flachkabeln, Chipkartenmodulen, Sitzheizungen, Folienleitern oder Leiterbahnen in LCD- oder Plasmabildschirmen.

## Claims

1. A process for producing structured or full-area, electrically conductive surfaces on a substrate (1), comprising the following steps:
a. transferring electrolessly and/or electrolytically coatable particles or a dispersion (3) comprising electrolessly and/or electrolytically coatable particles from a transfer medium (5) onto the substrate (1), the electrolessly and/or electrolytically coatable particles being transferred by introducing energy with a laser (7) into the electrolessly and/or electrolytically coatable particles or the dispersion (3) comprising the electrolessly and/or electrolytically coatable particles,
b. fixing the electrolessly and/or electrolytically coatable particles on the substrate (1),
wherein the transfer in step (a) is promoted by virtue of the particles being magnetic or magnetizable or, in the case of transfer of a dispersion, magnetic or magnetizable particles being present in the dispersion, and a magnetic field (9) is applied.

2. The process according to claim 1, wherein the magnetic field (9) is generated with a magnet (13) which is arranged below the substrate (1) to be coated.

3. The process according to claim 1 or 2, wherein the magnetic field is generated using an array comprising addressable magnet regions (19).

4. The process according to any of claims 1 to 3, wherein the laser (7) is a solid-state laser, a fiber laser, a diode laser, a gas laser or an excimer laser.

5. The process according to any of claims 1 to 4, wherein the laser (7) generates a laser beam with a wavelength in the range from 150 to 10 600 nm.

6. The process according to any of claims 1 to 5, wherein the electrolessly and/or electrolytically coatable particles comprise a magnetizable material.

7. The process according to claim 6, wherein the magnetizable material is iron, nickel, cobalt, NiFe, NiCuCo, NiCoFe, AlNi, AlNiCo, FeCoV, FeCo, FeSi, MnAlCu₂, SmCo or Nd₂Fe₁₄B.

8. The process according to any of claims 1 to 7, wherein the dispersion (3) comprises an absorbent.

9. The process according to any of claims 1 to 8, wherein the electrical conductive surface is coated electrolessly and/or electrolytically after being dried and/or cured.

10. The process according to any of claims 1 to 9, wherein the transfer medium (5) is a rigid or flexible plastic or glass which is transparent to the laser radiation used.

11. The process according to any of claims 1 to 10 for producing printed circuit boards, RFID antennas, transponder antennas, flat cables, chip card modules, seat heaters, foil conductors or conductor tracks in LCD or plasma visual display units.

## Revendications

1. Procédé pour la production de surfaces conductrices de l'électricité, structurées ou uniformes, sur un substrat (1), comprenant les étapes suivantes :
a. transfert de particules applicables par galvanoplastie et/ou sans courant ou d'une dispersion (3) contenant des particules applicables par galvanoplastie et/ou sans courant, d'un milieu se transfert (5) sur le substrat (1), l'énergie pour le transfert des particules applicables par galvanoplastie et/ou sans courant étant introduite par un laser (7) dans les particules applicables par galvanoplastie et/ou sans courant ou la dispersion (3) contenant les particules applicables par galvanoplastie et/ou sans courant,
b. fixage sur le substrat (1) des particules applicables par galvanoplastie et/ou sans courant,
**caractérisé en ce que** pour aider le transfert dans la couche (a) les particules sont magnétiques ou magnétisables ou dans le cas du transfert d'une dispersion des particules magnétiques ou magnétisables sont contenues dans la dispersion et on applique un champ magnétique (9).

2. Procédé selon la revendication 1, **caractérisé en ce qu'**on engendre le champ magnétique (9) à l'aide d'un aimant (13) qui est placé au-dessous du substrat (1) à revêtir.

3. Procédé selon la revendication 1 ou 2, **caractérisé en ce que** pour engendrer le champ magnétique on utilise un réseau à zones magnétiques adressables (19).

4. Procédé selon l'une quelconque des revendications 1 à 3, caractérisé en ce le laser (7) est un laser à corps solide, un laser à fibre, un laser à diodes, un laser à gaz ou un laser à excimères.

5. Procédé selon l'une quelconque des revendications 1 à 4, **caractérisé en ce que** le laser (7) engendre un rayon laser ayant une longueur d'onde dans la plage de 150 à 10 600 nm.

6. Procédé selon l'une quelconque des revendications 1 à 5, caractérisé en ce les particules applicables par galvanoplastie et/ou sans courant contiennent une matière magnétisable.

7. Procédé selon la revendication 6, **caractérisé en ce que** la matière magnétisable est le fer, le nickel, le cobalt, NiFe, NiCuCo, NiCoFe, AlNi, AlNiCo, FeCoV, FeCo, FeSi, MnAlCu₂, SmCo ou Nd₂Fe₁₄B.

8. Procédé selon l'une quelconque des revendications 1 à 7, **caractérisé en ce que** la dispersion (3) contient un absorbant.

9. Procédé selon l'une quelconque des revendications 1 à 8, **caractérisé en ce que** la surface conductrice de l'électricité est revêtue sans courant et/ou par galvanoplastie après le séchage et/ou le durcissement.

10. Procédé selon l'une quelconque des revendications 1 à 9, **caractérisé en ce que** le milieu de transfert (5) est un verre ou une matière plastique rigide ou flexible, transparent(e) au rayonnement laser utilisé.

11. Procédé selon l'une quelconque des revendications 1 à 10, pour la fabrication de cartes à circuits imprimés, d'antennes RFID, d'antennes de transpondeurs, de câbles en nappe, de modules de cartes à puces, de chauffages de sièges, de conducteurs en film ou de pistes conductrices dans des écrans LCD ou plasma.
